# EUROPEAN PATENT APPLICATION

(11) **EP 2 093 808 A2**
(43) Date of publication of application: **26.08.2009**
(21) Application number: 09002379.7
(22) Date of filing: 20.02.2009
(51) Int. Cl.: H01L 31/052, H01L 31/058

(54) **Multiple cooling systems of photovoltaic panels**

(30) Priority: 20.02.2008 IT MI20080264
(71) Applicant: Di Donato, Alfonso, 21054 Fagnano Olona (VA) (IT)
(72) Inventor: Di Donato, Alfonso, 21054 Fagnano Olona (VA) (IT)

(57) **Abstract**

This invention uses a cooling system, not necessarily integrated, to increase the production of electricity of the photovoltaic panels.

The cooling system is based on the principle that the power produced from a photovoltaic panel is dependent and sensitive to temperature increases, as with the increasing of the panel temperature decreases the power produced. In addition, the heat present on the photovoltaic panels is removed by the cooling system and with a heat pump the heat can be used for different objectives (i.e. It can be used to heat sanitary water or the liquid of the heating system).

## Description

In the name of Alfonso Di Donato, born in Atri (TE), on the 25.7.1971 (CF.

DDNLNS71L25A488W) and resident at Corridoni street, no. 22/B, 21054 Fagnano Olona (VA), of Italian nationality, submission dated 20 February 2008 with no. MI2008A000264

### SUMMARY

This invention uses a cooling system, not necessarily integrated, to increase the production of electricity of the photovoltaic panels.

The cooling system is based on the principle that the power produced from a photovoltaic panel is dependent and sensitive to temperature increases, as with the increasing of the panel temperature decreases the power produced. In addition, the heat present on the photovoltaic panels is removed by the cooling system and with a heat pump the heat can be used for different objectives (i.e. It can be used to heat sanitary water or the liquid of the heating system).

### DESCRIPTION

With this invention we want to increase the production of energy of the photovoltaic panels using some mechanism that, as alternative or combined, can provide the cooling. This patent differs from others as the cooling system is realized without any use of heat exchangers in different ways, and these different solutions can be used as alternative, together and / or partially combined, and the cooling system is not necessarily integrated in the photovoltaic panel.

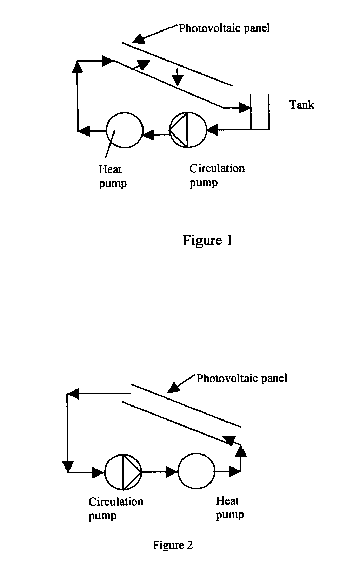

Consider fig. 1, the 1st mechanism places some sprinklers behind the photovoltaic panels, and these sprinklers cool the panels. The fluid then is collected in a tank and sent to a circuit where the heat pump is located. The heat pump removes the heat absorbed from the fluid, and transfer this heat to another fluid (this other fluid could be, for example, the water of a circuit for heating or water used for domestic uses). In this way, it decreases the operating temperature of the photovoltaic panels.

In case of the cooling system not functioning, the mechanism is designed in such a way that air can naturally cool the photovoltaic panels, by air circulation (not integrated solution).

The sprinklers could also cool the front side of the photovoltaic panels, if they are positioned on the sides of the photovoltaic panels.

A second mechanism considers that the cooling liquid can flow inside some plates placed behind the photovoltaic panels. In more detail, this can be realized by a film that provides cooling of the panels, or filling the bottom of the photovoltaic panel with a cooling liquid (in this case the back of the panel acts as a tank filled from the bottom) the liquid is then collected from the top of the panel and sent to the heat pump (fig. 2).

In the last case, materials with high specific heat (i.e.PCM) can be used to keep the temperature as constant as much as possible.

As optional design, it is also possible to add a heat exchanger so that it can supply heat before arriving to the heat pumps (for example an heat exchanger in a chimney or similar).

Last cooling mechanism considers the cooling using 1 or more ventilators placed behind, and/or on the sides of the photovoltaic panels

## Claims

1. Possibility of cooling during the production of electricity by photovoltaic panels with a system not necessarily integrated in the panels

2. Cooling in the back of the photovoltaic panels and/or on the front part of the photovoltaic panels using a liquid

3. Cooling circuit where the heat is removed by heat pump

4. Cooling using sprayers

5. Cooling using plates

6. Cooling by filling the liquid behind the photovoltaic panels and starting to fill from the lower part of the panels (like the panel is a tank)

7. Use, behind the photovoltaic panels, materials with high specific heat (for example PCM)

8. Cooling circuit that considers, as an option, a heat exchanger that heats the fluid more before arriving to the heat pump

9. Cooling of the photovoltaic panels by ventilators placed behind the photovoltaic panels and/or on the side/sides of the photovoltaic panels

10. Combined use or separated use of 1 or more of the solutions specified in the claims specified in points from 1 to 9, on any side/sides of the photovoltaic panels.
